# FASCICULE DE BREVET EUROPEEN

(11) **EP 4 125 141 B1**
(45) Date de publication et mention de la délivrance du brevet: **28.08.2024**
(21) Numéro de dépôt: 22187449.8
(22) Date de dépôt: 28.07.2022
(51) Int. Cl.: H10B 63/00, H10N 70/00, H10N 70/20

(54) **MEMOIRE A CHANGEMENT DE PHASE**
PHASENWECHSELSPEICHER
PHASE CHANGE MEMORY

(30) Priorité: 30.07.2021 FR 2108320
(43) Date de publication de la demande: 01.02.2023
(73) Titulaire: STMicroelectronics (Crolles 2) SAS, 38920 Crolles (FR); STMicroelectronics S.r.l., 20864 Agrate Brianza (MB) (IT)
(72) Inventeur: CAPPELLETTI, Paolo Giuseppe, 20030 Seveso (MI) (IT); PIAZZA, Fausto, 38000 Grenoble (FR); REDAELLI, Andrea, 20133 Milano (IT)
(74) Mandataire: Cabinet Beaumont

(56) Documents cités:
- US-A1- 2008 048 213
- US-A1- 2009 032 796
- MERGET F ET AL: "Lateral phase change random access memory cell design for low power operation", MICROSYSTEM TECHNOLOGIES ; MICRO AND NANOSYSTEMS INFORMATION STORAGE AND PROCESSING SYSTEMS, SPRINGER, BERLIN, DE, vol. 13, no. 2, 5 April 2006 (2006-04-05), pages 169 - 172, XP019461439, ISSN: 1432-1858, DOI: 10.1007/S00542-006-0141-Z

## Description

### Domaine technique

La présente description concerne de façon générale les dispositifs mémoire, et plus particulièrement des cellules mémoire à changement de phase.

### Technique antérieure

Des matériaux à changement de phase sont des matériaux qui peuvent commuter, sous l'effet de la chaleur, entre une phase cristalline et une phase amorphe. Comme la résistance électrique d'un matériau amorphe est significativement supérieure à la résistance électrique d'une phase cristalline du même matériau, un tel phénomène est utilisé pour définir deux états mémoire, par exemple, 0 et 1, différentiés par la résistance mesurée dans le matériau à changement de phase. Les matériaux à changement de phase les plus courants utilisés pour fabriquer des mémoires sont des alliages constitués de germanium, d'antimoine et de tellure. US 2009/0032796 A1 divulgue une cellule mémoire à changement de phase sous forme latérale, comprenant une couche d'un matériau à changement de phase en contact avec une électrode et avec une piste conductrice, la piste conductrice étant encastrée dans un élément isolant. US 2008/0048213 A1 montre une structure similaire (la couche de matériau à changement de phase étant située entre deux couches isolantes et ayant des électrodes latérales).

### Résumé de l'invention

Un mode de réalisation pallie tout ou partie des inconvénients des mémoires à changement de phase connues.

Un mode de réalisation prévoit une cellule mémoire comprenant un substrat comprenant une région semiconductrice et une région isolante, une première couche isolante et une deuxième couche d'un matériau à changement de phase reposant sur la première couche isolante, la première couche isolante étant traversée par des premier et deuxième vias conducteurs, le premier via conducteur étant en contact, par une extrémité, avec la première couche et, par une autre extrémité, avec la région semiconductrice, le deuxième via conducteur étant en contact, par une extrémité, avec la première couche et une piste conductrice d'un réseau d'interconnexions recouvrant la première couche et, par une autre extrémité, seulement avec la région isolante.

Un autre mode de réalisation prévoit un procédé de fabrication d'une cellule mémoire comprenant : a) la formation d'un substrat comprenant une région semiconductrice et une région isolante ; b) la formation d'une première couche isolante qui est traversée par des premier et deuxième vias conducteurs, et c) la formation d'une deuxième couche de matériau à changement de phase reposant sur la première couche isolante, le premier via conducteur étant en contact, par une extrémité, avec la première couche et, par une autre extrémité, avec la région semiconductrice, le deuxième via conducteur étant en contact, par une extrémité, avec la première couche et une piste conductrice d'un réseau d'interconnexions recouvrant la première couche et, par une autre extrémité, seulement avec la région isolante.

Selon un mode de réalisation, la région semiconductrice est une région de source ou de drain d'un transistor.

Selon un mode de réalisation, la deuxième couche est recouverte d'une troisième couche isolante.

Selon un mode de réalisation, la hauteur de la deuxième couche est inférieure à la hauteur de la piste conductrice.

Selon un mode de réalisation, la piste conductrice et la deuxième couche sont séparées par une partie d'un matériau isolant.

Selon un mode de réalisation, la deuxième couche est au moins partiellement dans un état cristallin.

Selon un mode de réalisation, le procédé comprend une étape d), qui suit l'étape c), de formation du réseau d'interconnexions sur la deuxième couche.

Selon un mode de réalisation, le procédé comprend une étape c1), entre les étapes c) et d), de formation d'une couche de protection sur la deuxième couche.

Selon un mode de réalisation, le procédé comprend, avant l'étape d), la gravure de la couche de protection afin de former des espaceurs sur les flancs de la deuxième couche.

Un autre mode de réalisation prévoit une matrice mémoire comprenant une pluralité de cellules mémoire telles que décrites précédemment.

Selon un mode de réalisation, la matrice mémoire comprend au moins une cellule ayant une deuxième couche partiellement à l'état amorphe.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente deux cellules mémoire à changement de phase selon un mode de réalisation ;
la figure 2 représente, schématiquement, l'implantation des différentes parties du mode de réalisation de la figure 1 ;
la figure 3 représente une étape d'un mode de réalisation d'un procédé de fabrication du mode de réalisation de la figure 1 ;
la figure 4 représente une autre étape d'un mode de réalisation d'un procédé de fabrication du mode de réalisation de la figure 1 ;
la figure 5 représente une autre étape d'un mode de réalisation d'un procédé de fabrication du mode de réalisation de la figure 1 ;
la figure 6 représente une autre étape d'un mode de réalisation d'un procédé de fabrication du mode de réalisation de la figure 1 ;
la figure 7 représente une autre étape d'un mode de réalisation d'un procédé de fabrication du mode de réalisation de la figure 1 ; et
la figure 8 représente un autre mode de réalisation d'une mémoire à changement de phase.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

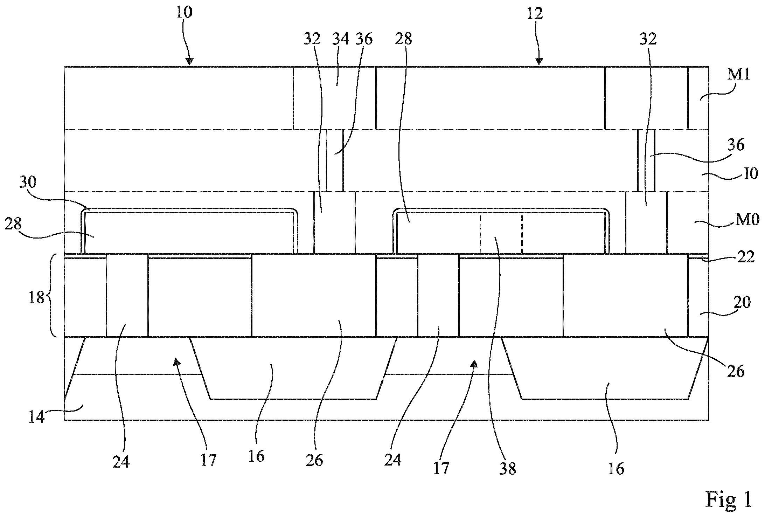

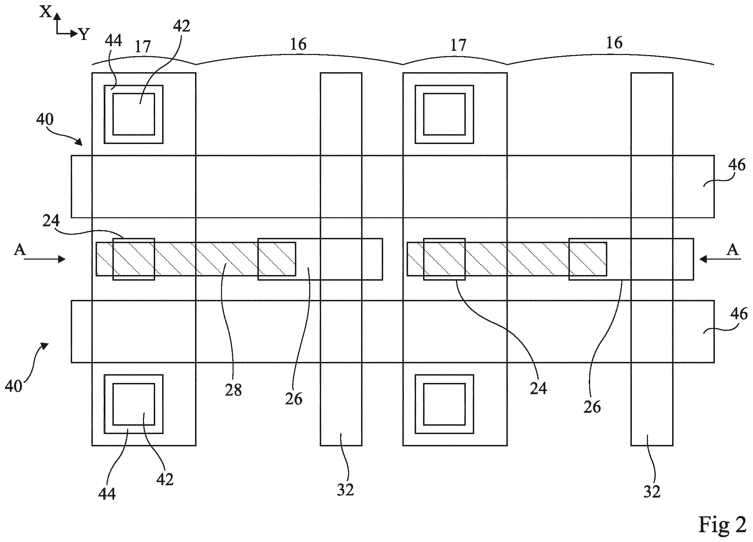

La figure 1 représente deux cellules mémoire à changement de phase 10 et 12 selon un mode de réalisation. La figure 1 est dans un plan AA de la figure 2. Les cellules 10 et 12 font parties d'une matrice mémoire comprenant une pluralité de cellules 10, 12 disposées en lignes et en colonnes pour former des lignes de mot et des lignes de bit.

Les cellules mémoire 10 et 12 sont formées sur un substrat 14. Le substrat 14 est en un matériau semiconducteur, par exemple en silicium. Des régions isolantes 16 sont formées dans le substrat 14. Les régions isolantes 16 sont en un matériau isolant, par exemple en oxyde de silicium ou en nitrure de silicium. Chaque cellule 10, 12 est située en face d'une région 16 et d'une région 17 du substrat sensiblement au même niveau que les régions 16. En d'autres mots, la surface supérieure des régions 16 et 17 sont sensiblement au même niveau.

Les régions 17 sont par exemple dopées. Par exemple, les régions 17 correspondent aux régions de source ou de drain, de préférence de drain, de transistors.

Le substrat 14, et les régions 16, sont recouvertes d'une couche isolante 18. La couche 18 peut être une seule couche d'un seul matériau isolant ou un empilement de plus d'une couche de matériau isolant. Dans l'exemple de la figure 1, l'empilement 18 comprend une première couche 20, par exemple en oxyde de silicium, recouverte d'une deuxième couche 22 de l'empilement, par exemple en nitrure de silicium.

Chaque cellule 10, 12 comprend un premier contact conducteur, ou via, 24. Chaque contact 24 traverse l'empilement 18. Chaque contact 24 s'étend depuis une des régions 17, et est en contact, par une première extrémité, avec ladite région 17. Chaque contact 24 s'étend depuis la régions 17 jusqu'à la surface supérieure de l'empilement 18.

Chaque cellule 10, 12 comprend un deuxième contact conducteur, ou via, 26. Chaque contact 26 traverse l'empilement 18. Chaque contact 26 s'étend depuis une des régions 16, et est en contact, par une première extrémité, avec ladite région 16. De préférence, la surface inférieure du contact 26, en d'autres mots la surface en contact avec la région 16, est uniquement en contact avec la région 16. Les contacts 26 ne sont pas en contact avec le substrat 14, et, en particulier, ne sont pas en contact avec les régions 17. Chaque contact 26 s'étend depuis la région 16 jusqu'à la surface supérieure de l'empilement 18. Le contact 26 est séparé du contact 24 par une partie de l'empilement 18.

Chaque cellule 10, 12 comprend une couche, ou une partie, 28 en un matériau cristallin à changement de phase, par exemple en un alliage de germanium, de tellure et d'antimoine.

La couche 28 de chaque cellule recouvre au moins partiellement le contact 24. Par conséquent, le contact 24 est au moins partiellement en contact, par une deuxième extrémité, avec la couche 28. Un côté de la couche 28 est par conséquent reliée au substrat par le contact 24. La couche 28 de chaque cellule recouvre partiellement le contact 26. Par conséquent, le contact 26 est partiellement en contact, par une deuxième extrémité, avec la couche 28. Une partie de la deuxième extrémité du contact 26, en d'autres mots de la surface supérieure du contact 26, n'est pas recouverte par la couche 28. Le contact 26 n'est pas en contact avec le substrat 14.

La couche 28 de chaque cellule est de préférence recouverte par une couche de protection 30, par exemple en un matériau isolant, par exemple en nitrure de silicium. De préférence, la couche 30 recouvre la surface supérieure de la couche 28 et les surfaces latérales.

La structure précédemment décrite est recouverte par un réseau d'interconnexions. Le réseau d'interconnexions comprend un empilement de couches isolantes, chaque couche comprenant soit des pistes conductrices, soit des vias conducteurs. Le réseau d'interconnexions comprend une couche isolante M0, recouvrant la couche 30, et par conséquent la couche 28. La couche M0 recouvre de préférence également la partie du contact 26 et de l'empilement 18 qui ne sont pas recouvertes par la couche 28. Des pistes conductrices 32 sont situées dans la couche isolante M0. Les pistes conductrices 32 traversent la couche M0. En d'autres mots, les pistes conductrices 32 s'étendent depuis la surface inférieure de la couche M0, en d'autres mots la surface la plus proche du contact 26, jusqu'à la surface supérieure de la couche M0.

Chaque contact 26 est connecté, par la deuxième extrémité, avec une piste conductrice 32. En d'autres mots, une piste conductrice 32 est en contact avec chaque contact 26, plus précisément avec la partie du contact 26 non recouverte par la couche 28. La piste conductrice 32 n'est pas en contact avec la couche 28. Par conséquent, la piste conductrice 32 est séparée de la couche 28 par la couche 30 et une partie de la couche M0.

Le réseau d'interconnexions comprend en outre une couche isolante M1l, comprenant des pistes conductrices 34, la couche M1 étant séparée de la couche M0 par une couche I0, comprenant des vias conducteurs 36. En d'autres mots, la couche I0 recouvre la couche M0 et la couche M1 recouvre la couche I0. Les pistes 34 sont reliées aux pistes 32 par les vias 36.

La hauteur de la couche 28 est inférieure à la hauteur de la couche M0. De préférence, la hauteur des couches 28 et 30 est inférieure à la hauteur de la couche M0.

Chaque cellule est programmée en appliquant un courant de programmation entre la région 17 et la piste conductrice 32. En d'autres mots, un courant électrique traverse la région 17, le contact 24, la couche 28, le contact 26 et la piste conductrice 32. Le courant appliqué est suffisant pour chauffer la couche 28 et créer une région amorphe 38 dans la couche 28.

La cellule 10 de la figure 1 ne comprend pas la région 38 et la cellule 12 comprend la région 38. Les impédances des cellules sont suffisamment différentes pour qu'une telle différence puisse être mesurée. Par conséquent, la cellule 10 correspond à une donnée stockée correspondant à un premier nombre binaire, par exemple '0', et la cellule 12 correspond à une donnée stockée correspondant à un deuxième nombre binaire, par exemple '1'.

La figure 2 représente, schématiquement, l'implantation des différentes parties du mode de réalisation de la figure 1. La figure 2 est une vue de dessus des cellules 10, 12 de la figure 1 situées dans une matrice mémoire, toutefois les différents éléments représentés ne sont pas tous dans le même plan.

La figure 2 représente une alternance de bandes des régions 17 et 16, dans le substrat. Les bandes s'étendent selon une direction X dans le plan de la figure 2, correspondant par exemple à la direction d'une ligne de bit de la matrice mémoire.

Un contact 24 est situé sur chaque bande 17 pour chaque cellule. Un contact 26 est situé sur chaque bande 16 pour chaque cellule. Une couche 28 est située sur les contacts 24 et 26 de chaque cellule, comme cela a été décrit en relation avec la figure 1. La couche 28 s'étend dans une direction Y dans le plan de la figure 2, perpendiculaire à la direction X. La direction Y correspond par exemple à une ligne de mot de la matrice mémoire.

Les pistes 32 s'étendent dans la direction X et sont en contact avec plusieurs cellules, de préférence toutes les cellules d'une même ligne de bit.

La matrice mémoire comprend en outre des éléments de sélection 40, de préférence des transistors, formés dans les régions 17. Chaque transistor 40 comprend des régions de drain et de source, dont une, par exemple le drain, est située dans une des régions 17 sous, et en contact avec, le contact 24 et l'autre est située dans la même région 17. Par exemple, comme dans l'exemple de la figure 2, la partie de la région 17 sous chaque contact 24 constitue une région de drain (ou de source) pour deux transistors, la région de source (ou de drain) de chacun des deux transistors étant dans la région 17, de préférence d'un côté opposé du contact 24 dans la direction X.

Des vias conducteurs 42, par exemple identiques au contact 24, traversent la couche isolante 18. Un des vias 42 est en contact avec chaque région de source (ou de drain) des transistors 40 qui ne sont pas en contact avec un contact 24. Une piste conductrice 44 située dans la couche M0 est en contact avec chaque via 42. De préférence, les pistes 44 des régions de source (ou de drain) d'une même ligne de mot, en d'autres mots les pistes 44 alignées dans la direction Y, sont reliées entre elles, par exemple par des pistes conductrices.

Les grilles des transistors sont par exemple communes aux transistors d'une même ligne de mot, en d'autres mots les transistors 40 alignés dans la direction Y. Les grilles sont représentées par des bandes 46 qui s'étendent dans la direction Y.

Afin de programmer une des cellules, le courant de programmation circule depuis une piste 44, un via 42 et la région 17 pour atteindre le contact 24.

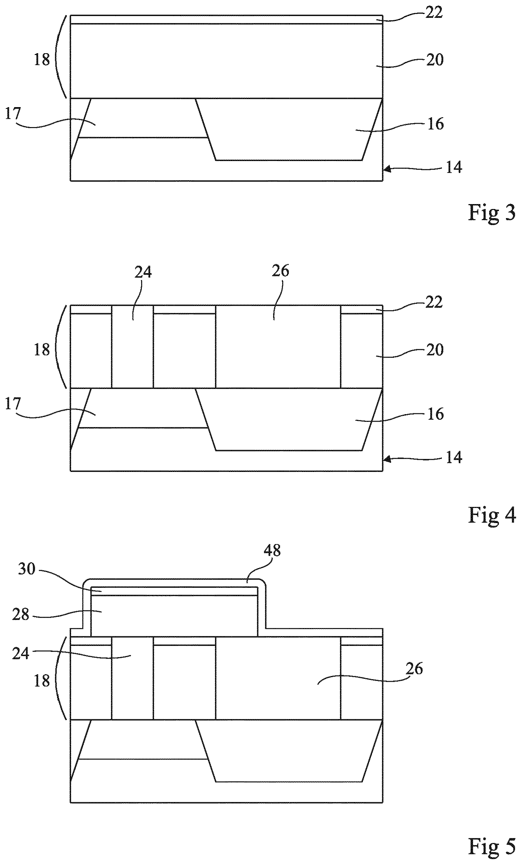

Les figures 3 à 7 représentent des étapes, de préférence des étapes successives, d'un procédé de fabrication du mode de réalisation de la figure 1. Les figures 3 à 7 sont des vues latérales dans le plan de la figure 1 représentant une seule cellule mémoire, par exemple la cellule 10.

La figure 3 représente une étape d'un mode de réalisation d'un procédé de fabrication du mode de réalisation de la figure 1.

Cette étape comprend la formation, dans le substrat 14, des régions isolantes 16 et des régions 17. La formation des régions 16 comprend par exemple la formation de cavités dans le substrat 14 et le remplissage de ces cavités avec un matériau isolant.

Cette étape comprend en outre la formation des éléments de sélection, par exemple des transistors 40, dans et sur le substrat, plus précisément sur et dans les régions 17. La formation des transistors 40 comprend par exemple le dopage des régions 17, afin de former les régions de drain et de source, et la formation de la grille sur le substrat.

Cette étape comprend le dépôt de la couche, ou de l'empilement de couches, 18 sur le substrat 14 et les régions 16. Plus précisément, dans l'exemple de la figure 3, cette étape comprend le dépôt d'une couche 20 sur le substrat et les régions 16, et en particulier sur les régions 16 et 17, et le dépôt d'une couche 22 sur la couche 20. De préférence, la couche, ou l'empilement de couches, 18 est déposé sur toute la structure.

La figure 4 représente une autre étape d'un mode de réalisation d'un procédé de fabrication du mode de réalisation de la figure 1.

Cette étape comprend la formation des contacts 24 et 26. La formation des contacts 24 et 26 comprend par exemple la formation de cavités dans l'empilement 18 et le remplissage de ces cavités avec un matériau conducteur, par exemple un métal. Les cavités traversent l'empilement 18 afin d'atteindre les régions 17, dans le cas des cavités correspondant aux contacts 24, et les régions 16, dans le cas des cavités correspondant aux contacts 26.

La figure 5 représente une autre étape d'un mode de réalisation d'un procédé de fabrication du mode de réalisation de la figure 1.

Cette étape comprend la formation de la couche 28 et de la couche 30 sur les contacts 24 et 26 et sur l'empilement 18. En d'autres mots, la couche 28 recouvre les contacts 24 et 26 et l'empilement 18 et la couche 30 recouvre la couche 28. De préférence, les couches 28 et 30 recouvrent, une fois déposées, toute la structure formée à l'étape illustrée par la figure 4.

Les couches 28 et 30 sont gravées afin d'obtenir les couches 28 et 30 décrites en relation avec la figure 1. En d'autres mots, les couches 28 et 30 sont gravées afin de former des bandes s'étendant depuis un contact 24 vers un contact 26, recouvrant au moins partiellement le contact 24 et partiellement le contact 26. Chaque empilement de couches 28, 30, après avoir été gravé, recouvre un seul contact 24 et recouvre partiellement un seul contact 26.

Cette étape comprend également la formation d'une couche de protection 48. La couche 48 est de préférence en un matériau isolant, par exemple le même matériau que la couche 30, par exemple en nitrure de silicium. La couche 48 recouvre de préférence toute la structure résultant de l'étape de gravure décrite en relation avec la figure 5. Plus précisément, la couche 48 est formée de façon conforme sur la surface supérieure de la couche 30, sur les flancs des couches 28 et 30, sur les contacts 26 et sur l'empilement 18.

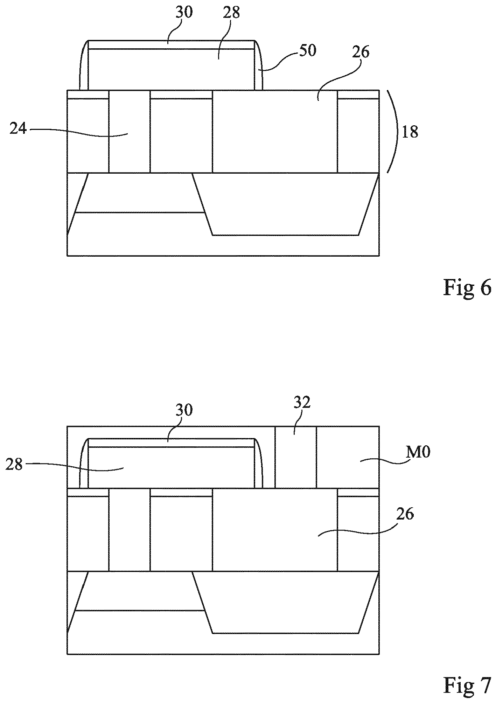

La figure 6 représente une autre étape d'un mode de réalisation d'un procédé de fabrication du mode de réalisation de la figure 1.

Cette étape correspond à la formation d'espaceurs 50 sur les flancs des couches 28 et 30. Plus précisément, la couche 48 est gravée par gravure anisotrope. Les parties de la couche 48 situées sur la surface supérieure de la couche 30 et sur la surface supérieure des contacts 26 et de l'empilement 18 sont retirées. En d'autres mots, toute la couche 48, sauf la partie sur les flancs des couches 28 et 30, est de préférence gravée.

La figure 7 représente une autre étape d'un mode de réalisation d'un procédé de fabrication du mode de réalisation de la figure 1.

Cette étape comprend la formation du réseau d'interconnexions. La figure 7 représente uniquement la formation du premier niveau M0. D'autres niveaux, en d'autres mots d'autres couches, du réseau d'interconnexions sont formés sur la couche M0, mais ne sont pas représentées en figure 7.

L'étape représentée en figure 7 comprend la formation de la couche isolante M0 sur la structure résultant de l'étape de la figure 6 et la formation des pistes conductrices 32 dans la couche M0.

La couche M0 est configurée pour recouvrir entièrement les couches 28 et 30. Par conséquent, la formation des couches du niveau d'interconnexions au-dessus de la couche M0 n'est pas impactée par la présence des cellules mémoire.

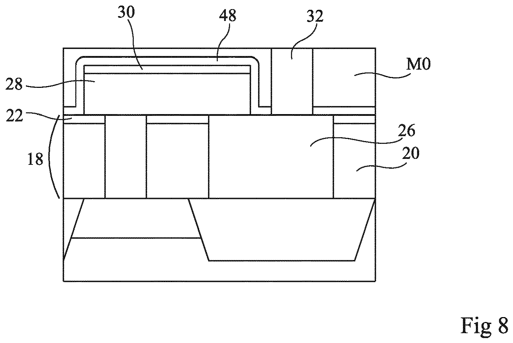

La figure 8 représente un autre mode de réalisation d'une mémoire à changement de phase.

Le mode de réalisation de la figure 8 diffère du mode de réalisation de la figure 1 en ce que la couche isolante M0 est séparée de l'empilement comprenant les couches 28 et 30, du contact 26 et de l'empilement 18 par la couche de protection 48. Les pistes conductrices 32 s'étendent par conséquent à travers la couche M0 et la couche 48 afin d'être en contact avec le contact 26.

Le procédé de fabrication du mode de réalisation de la figure 8 diffère du procédé décrit en relation avec les figures 4 à 7 en ce qu'il ne comprend pas l'étape de la figure 6. En d'autres mots, la couche 48 n'est pas gravée afin de former les espaceurs 50. L'étape de la figure 7 diffère en ce que la couche M0 recouvre la couche 48 et que la formation des pistes conductrices 32 comprend la gravure de la couche M0 et de la couche 48 au niveau de l'emplacement des pistes 32.

On pourrait avoir choisi de créer un élément résistif, par exemple ayant une forme en L, entre le contact 24 et la couche 28. En outre, on pourrait avoir choisi de connecter la cellule au réseau d'interconnexions par une couche conductrice recouvrant la couche 28 et un via depuis la couche I0. Bien qu'une telle structure aurait permis de fabriquer une matrice mémoire ayant une plus grande densité et consommant moins d'énergie pour chaque programmation, le procédé de fabrication nécessiterait bien plus d'étapes, et en particulier plusieurs masques de gravure supplémentaires, qui sont coûteux. Dans certaines applications, la matrice mémoire correspond à une très petite partie d'un circuit, et est rarement utilisée. Par exemple, dans une telle application, la matrice mémoire peut être programmée une fois pour toute et jamais, ou rarement, modifiée par la suite. Dans une telle application, une grande densité et une faible consommation ne sont pas comparables au coût correspondant de fabrication.

Un avantage du mode de réalisation décrit est que seulement les couches 28 et 30 sont situées dans la couche M0. La hauteur des couches 28 et 30 peut être réalisée plus faible que la hauteur de la couche M0. Par conséquent, la présence des cellules 10, 12 ne modifie avantageusement pas la structure et la fabrication du réseau d'interconnexions

Divers modes de réalisation et variantes ont été décrits. La personne du métier comprendra que certaines caractéristiques de ces divers modes de réalisation et variantes pourraient être combinées, et d'autres variantes apparaîtront à la personne du métier, la portée de l'invention étant définie par les revendications.

Enfin, la mise en oeuvre pratique des modes de réalisation et variantes décrits est à la portée de la personne du métier à partir des indications fonctionnelles données ci-dessus.

## Revendications

1. Cellule mémoire comprenant un substrat comprenant une région semiconductrice (17) et une région isolante (16), une première couche isolante (18) et une deuxième couche (28) d'un matériau à changement de phase reposant sur la première couche isolante (18), la première couche isolante (18) étant traversée par des premier (24) et deuxième (26) vias conducteurs, le premier via conducteur étant en contact, par une extrémité, avec la deuxième couche (28) et, par une autre extrémité, avec la région semiconductrice (17), le deuxième via conducteur (26) étant en contact, par une extrémité, avec la deuxième couche (28) et une piste conductrice (32) d'un réseau d'interconnexions recouvrant la première couche et, par une autre extrémité, seulement avec la région isolante.

2. Cellule mémoire selon la revendication 1, dans lequel la région semiconductrice (17) est une région de source ou une région de drain d'un transistor (40).

3. Cellule mémoire selon la revendication 1 ou 2, dans lequel la deuxième couche (28) est recouverte d'une troisième couche isolante (30).

4. Cellule mémoire selon l'une quelconque des revendications 1 à 3, dans lequel la hauteur de la deuxième couche (28) est inférieure à la hauteur de la piste conductrice (32).

5. Cellule mémoire selon l'une quelconque des revendications 1 à 4, dans lequel la piste conductrice (32) et la deuxième couche (28) sont séparées par une partie d'un matériau isolant.

6. Cellule mémoire selon l'une quelconque des revendications 1 à 5, dans lequel la deuxième couche (28) est au moins partiellement dans un état cristallin.

7. Procédé de fabrication d'une cellule mémoire comprenant :
a) la formation d'un substrat comprenant une région semiconductrice (17) et une région isolante (16) ;
b) la formation d'une première couche isolante (18) qui est traversée par des premier (24) et deuxième (26) vias conducteurs, et
c) la formation d'une deuxième couche (28) de matériau à changement de phase reposant sur la première couche isolante (18),
le premier via conducteur étant en contact, par une extrémité, avec la première couche (28) et, par une autre extrémité, avec la région semiconductrice (17), le deuxième via conducteur (26) étant en contact, par une extrémité, avec la première couche (28) et une piste conductrice (32) d'un réseau d'interconnexions recouvrant la première couche et, par une autre extrémité, seulement avec la région isolante.

8. Procédé de fabrication selon la revendication 7, appliqué à une cellule mémoire selon l'une quelconque des revendications 1 à 6.

9. Procédé selon la revendication 7 ou 8, comprenant une étape d), qui suit l'étape c), de formation du réseau d'interconnexions sur la deuxième couche (28).

10. Procédé selon la revendication 9, comprenant une étape c1), entre les étapes c) et d), de formation d'une couche de protection (48) sur la deuxième couche (28).

11. Procédé selon la revendication 10, comprenant, avant l'étape d), la gravure de la couche de protection (48) afin de former des espaceurs (50) sur les flancs de la deuxième couche (28).

12. Matrice mémoire comprenant une pluralité de cellules mémoire selon l'une quelconque des revendications 1 à 6.

13. Matrice mémoire selon la revendication 12, comprenant au moins une cellule (12) ayant une deuxième couche (28) partiellement à l'état amorphe.

## Patentansprüche

1. Speicherzelle aufweisend ein Substrat mit einem Halbleiterbereich (17) und einem Isolierbereich (16), eine erste Isolierschicht (18) und eine zweite Schicht (28) aus einem Phasenwechselmaterial, die auf der ersten Isolierschicht (18) ruht, wobei die erste Isolierschicht (18) von einer ersten (24) und einer zweiten (26) leitenden Durchkontaktierung gekreuzt wird, wobei die erste leitende Durchkontaktierung an einem Ende mit der zweiten Schicht (28) und an einem anderen Ende mit dem Halbleiterbereich (17) in Kontakt steht, wobei die zweite leitende Durchkontaktierung (26) an einem Ende mit der ersten Schicht (28) und einer Leiterbahn (32) eines die erste Schicht bedeckenden Verbindungsnetzes und an einem anderen Ende nur mit dem isolierenden Bereich in Kontakt steht.

2. Speicherzelle nach Anspruch 1, bei der der Halbleiterbereich (17) ein Source- oder ein Drain-Bereich eines Transistors (40) ist.

3. Speicherzelle nach Anspruch 1 oder 2, bei der die zweite Schicht (28) von einer dritten Isolierschicht (30) bedeckt ist.

4. Speicherzelle nach einem der Ansprüche 1 bis 3, bei der die Höhe der zweiten Schicht (28) geringer ist als die Höhe der Leiterbahn (32).

5. Speicherzelle nach einem der Ansprüche 1 bis 4, bei der die Leiterbahn (32) und die zweite Schicht (28) durch einen Abschnitt aus Isoliermaterial getrennt sind.

6. Speicherzelle nach einem der Ansprüche 1 bis 5, bei der die zweite Schicht (28) zumindest teilweise in einem kristallinen Zustand ist.

7. Verfahren zur Herstellung einer Speicherzelle, wobei das Verfahren Folgendes aufweist:
a) das Ausbilden eines Substrats, das einen Halbleiterbereich (17) und einen Isolierbereich (16) aufweist;
b) das Ausbilden einer ersten Isolierschicht (18), die von ersten (24) und zweiten (26) leitenden Durchkontaktierungen gekreuzt wird, und
c) das Ausbilden einer zweiten Schicht (28) aus Phasenwechselmaterial, die auf der ersten Isolierschicht (18) liegt, wobei die erste leitende Durchkontaktierung an einem Ende mit der ersten Schicht (28) und an einem anderen Ende mit dem Halbleiterbereich (17) in Kontakt steht, wobei die zweite leitende Durchkontaktierung (26) an einem Ende mit der ersten Schicht (28) und einer Leiterbahn (32) eines die erste Schicht bedeckenden Verbindungsnetzes und an einem anderen Ende nur mit dem Isolierbereich in Kontakt steht.

8. Herstellungsverfahren nach Anspruch 7, angewandt auf eine Speicherzelle nach einem der Ansprüche 1 bis 6.

9. Verfahren nach Anspruch 7 oder 8, das einen auf Schritt c) folgenden Schritt d) des Ausbildens des Verbindungsnetzes über der zweiten Schicht (28) aufweist.

10. Verfahren nach Anspruch 9, aufweisend einen Schritt c1) zwischen Schritt c) und d) des Ausbildens einer Schutzschicht (48) über der zweiten Schicht (28).

11. Verfahren nach Anspruch 10, das vor Schritt d) das Ätzen der Schutzschicht (48) aufweist, um Abstandshalter (50) an den Flanken der zweiten Schicht (28) zu bilden.

12. Speicheranordnung mit einer Vielzahl von Speicherzellen nach einem der Ansprüche 1 bis 6.

13. Speicheranordnung nach Anspruch 12, die mindestens eine Zelle (12) mit einer zweiten Schicht (28) aufweist, die sich teilweise in einem amorphen Zustand befindet.

## Claims

1. A memory cell comprising a substrate comprising a semiconductor region (17) and an insulating region (16), a first insulating layer (18) and a second layer (28) of phase change material resting on the first insulating layer (18), the first insulating layer (18) being crossed by first (24) and second (26) conductive vias, the first conductive via being in contact, by one extremity, with the second layer (28) and, by another extremity, with the semiconductor region (17), the second conductive via (26) being in contact, by one extremity, with the second layer (28) and a conductive track (32) of an interconnection network covering the first layer and, by another extremity, only with the insulating region.

2. The memory cell according to claim 1, in which the semiconductor region (17) is a source or a drain region of a transistor (40).

3. The memory cell according to claim 1 or 2, in which the second layer (28) is covered by a third insulating layer (30) .

4. The memory cell according to any of claims 1 to 3, in which the height of the second layer (28) is lower than the height of the conductive track (32).

5. The memory cell according to any of claims 1 to 4, in which the conductive track (32) and the second layer (28) are separated by a portion of insulating material.

6. The memory cell according to any of claims 1 to 5, in which the second layer (28) is at least partially in a crystallin state.

7. A method of manufacturing a memory cell comprising:
a) the formation of a substrate comprising a semiconductor region (17) and an insulating region (16);
b) the formation of a first insulating layer (18) being crossed by first (24) and second (26) conductive vias, and
c) the formation of a second layer (28) of phase change material resting on the first insulating layer (18),
the first conductive via being in contact, by one extremity, with the first layer (28) and, by another extremity, with the semiconductor region (17), the second conductive via (26) being in contact, by one extremity, with the first layer (28) and a conductive track (32) of an interconnection network covering the first layer and, by another extremity, only with the insulating region.

8. The manufacturing method of claim 7, applied to a memory cell according to any of claims 1 to 6.

9. The method according to claim 7 or 8, comprising a step d), following step c), of formation of the interconnection network over the second layer (28).

10. The method according to claim 9, comprising a step c1), between step c) and d), of formation of a protection layer (48) over the second layer (28).

11. The method according to claim 10, comprising, before step d), the etching of the protection layer (48) in order to form spacers (50) on the flanks of the second layer (28) .

12. A memory array comprising a plurality of memory cells according to any of claims 1 to 6.

13. The memory array according to claim 12, comprising at least one cell (12) with a second layer (28) partially in an amorphous state.
